# EUROPEAN PATENT APPLICATION

(11) **EP 4 283 670 A2**
(43) Date of publication of application: **29.11.2023**
(21) Application number: 23171445.2
(22) Date of filing: 04.05.2023
(51) Int. Cl.: H01L 23/498, H01L 23/538

(54) **MOLDED POWER MODULES**

(30) Priority: 04.05.2022 US 202263364166 P; 27.04.2023 US 202318308467
(71) Applicant: Semiconductor Components Industries, LLC, Scottsdale, AZ 85250 (US)
(72) Inventor: IM, Seungwon, 102-704 Bucheon (KR); JEON, Oseob, 06518 Seoul (KR)
(74) Representative: Manitz Finsterwald Patent- und Rechtsanwaltspartnerschaft mbB

(57) **Abstract**

In a general aspect, an electronic device assembly includes a substrate having a surface, a patterned metal layer disposed on the surface of the substrate, a semiconductor device circuit implemented on the patterned metal layer, and a molded body including a plurality of signal pin. A signal pin of the plurality of signal pins includes a first portion extending out of a first surface of the molded body. The first portion is externally accessible. The signal pin of the plurality of signal pins also includes a second portion extending out of a second surface of the molded body opposite the first surface. The second portion of the signal pin of the plurality of signal pins include is internal to the electronic device assembly, is electrically coupled with the patterned metal layer, and is electrically continuous with the first portion.

## Description

### TECHNICAL FIELD

This description relates to electronic device assemblies. More specifically, this description relates to semiconductor device modules, such as power semiconductor device modules, and associated electronic device assemblies.

### BACKGROUND

Semiconductor devices (e.g., semiconductor die) can be included in package assemblies or modules. Such modules can include a substrate, semiconductor die that are disposed on the substrate, electrical interconnections, and a molding compound. The electrical interconnections can include conductive clips, wire bonds, signal pins, and/or power tabs. The molding compound can encapsulate portions of the assembly, where at least portions of the signal pins and portions of the power tabs are accessible external to the molding compound, e.g., for electric connection in an associated system. In previous implementations, alignment of a substrate in a molding cavity for encapsulation in a molding compound can be difficult, which can result in improper location of the signal pins and/or the power tabs on the module. Further, power tabs in previous implementations can significantly contribute to stray inductance of an associated module due to their length, and/or physical configuration.

Further in previous implementations, modules with the same or similar functionality that are implemented in different package configurations can vary in their signal pin arrangements, which prevents interchangeability of one module configuration for another in an associated system. That is, layout of a printed circuit board in which a given module is included (incorporated, integrated, etc.) needs to be specific to the signal pin arrangement of the module. Additionally, individual signal pins in previous implementations are susceptible to being misaligned, e.g., due to slanting during attachment in the module. Still further in previous implementations, delamination of the molding compound from an associated thermal dissipation appliance (e.g., heat sink, fluidically-cooled jacket, etc.) to which the module is coupled can occur as a result of thermally cycling associated with long term use and/or during reliability testing.

### SUMMARY

In a general aspect, an electronic device assembly includes a substrate having a surface, a patterned metal layer disposed on the surface of the substrate, a semiconductor device circuit implemented on the patterned metal layer, and a molded body including a plurality of signal pins. A signal pin of the plurality of signal pins includes a first portion extending out of a first surface of the molded body. The first portion of the signal pin is externally accessible. The signal pin of the plurality of signal pins also includes a second portion extending out of a second surface of the molded body opposite the first surface. The second portion of the signal pin of the plurality of signal pins include is internal to the electronic device assembly, is electrically coupled with the patterned metal layer, and is electrically continuous with the first portion.

Implementations can include one or more of the following features, alone or in combination. For example, the second portion of the signal pin can include a plurality of bends.

The molded body can include a plurality of alignment features configured to position the electronic device assembly in an encapsulation molding tool. The plurality of alignment features can include at least one of a plurality of recesses in the first surface of the molded body, or a plurality of through-holes in the molded body.

The molded body can include a plurality of power tabs. A power tab of the plurality of power tabs can include a first portion arranged in a plane parallel to the first surface of the molded body, and a second portion orthogonal to the first portion. The second portion of the power tab can extend from the second surface of the molded body, be electrically continuous with the first portion of the power tab, and be electrically coupled with the patterned metal layer.

The first portion of the power tab can be disposed in a slot defined in the molded body.

The power tab can be a single body that is bent to define the first portion of the power tab and the second portion of the power tab.

The second portion of the power tab can be a conductive post that electrically couples the first portion of the power tab with the patterned metal layer.

In another general aspect, an electronic device assembly includes a substrate having a surface, a patterned metal layer disposed on the surface of the substrate, a semiconductor device circuit implemented on the patterned metal layer, and an interposer having a first side and a second side opposite the first side. The interposer includes a plurality of signal pin sockets accessible from the first side of the interposer, a plurality of caps respectively enclosing the plurality of signal pin sockets on the second side of the interposer, and at least one signal redistribution layer respectively electrically coupling the plurality of signal pin sockets to a plurality of contact pads on the second side of the interposer. The electronic device assembly also includes a plurality of electrically conductive posts respectively electrically coupling the plurality of contact pads with the patterned metal layer.

Implementations can include one or more of the following features, alone or in combination. For example, the electronic device assembly can include at least one electrical component disposed on the first side of the interposer. The at least one electrical component can be electrically coupled with at least one signal pin socket of the plurality of signal pin sockets via the at least one signal redistribution layer.

The interposer can include a printed circuit board.

The at least one signal redistribution layer can include a plurality of signal redistribution layers.

The interposer can include a plurality of cutouts. The electronic device assembly can include a plurality of power tabs respectively disposed in the plurality of cutout, and a plurality of conductive posts respectively electrically coupling the plurality of power tabs with the patterned metal layer.

The electronic device assembly can include a molding compound. The plurality of signal pin sockets can be exposed through the molding compound.

The electronic device assembly can include a plurality of signal pins respectively inserted in the plurality of signal pin sockets.

In another general aspect, an electronic device assembly includes a thermal dissipation appliance having a surface. The thermal dissipation appliance includes a first groove defined in the surface, and a second groove defined in the surface. The second groove is spaced from and parallel to the first groove. The electronic device assembly also includes a substrate coupled with a surface of the thermal dissipation appliance. The substrate is disposed between the first groove and the second groove. The electronic device assembly further includes a semiconductor device circuit implemented on the substrate, and a molding compound. A first portion of the molding compound encapsulates the substrate and the semiconductor device circuit. A second portion of the molding compound is disposed in the first groove, and a third portion of the molding compound is disposed in the second groove.

Implementations can include one or more of the following features, alone or in combination. For example, the first groove can extend from a first edge of the thermal dissipation appliance to a second edge of the thermal dissipation appliance, the second edge being opposite the first edge. The second groove can extend from the first edge of the thermal dissipation appliance to the second edge of the thermal dissipation appliance.

The thermal dissipation appliance can include a first protrusion disposed along the first edge of the thermal dissipation appliance between the first groove and the second groove. A fourth portion of the molding compound can encapsulate the first protrusion. The thermal dissipation appliance can include a second protrusion disposed along the second edge of the thermal dissipation appliance between the first groove and the second groove. A fifth portion of the molding compound can encapsulate the second protrusion.

The thermal dissipation appliance can be one of a heat sink, or a fluidically-cooled jacket.

The electronic device assembly can include a plurality of externally accessible signal pins; and a plurality of externally accessible power tabs.

### BRIEF DESCRIPTION OF THE DRAWINGS

FIG. 1 is a diagram illustrating an example electronic device assembly.
FIGs. 2A and 2B are diagrams illustrating an example molded body that can be included in the electronic device assembly of FIG. 1.
FIG. 3 is a diagram illustrating an example substrate assembly.
FIGs. 4A and 4B are diagrams illustrating example aspects of an electronic device assembly, such as the electronic device assembly of FIG. 1.
FIGs. 5A and 5B are diagrams illustrating another example molded body that can be included in an electronic device assembly
FIGs. 6A to 6C are diagrams illustrating example aspects of an electronic device assembly including the molded body of FIGs. 5A and 5B.
FIGs. 7A and 7B are diagrams illustrating another example electronic device assembly.
FIGs. 8A to 8D are diagrams illustrating various views of an interposer that can be included in the electronic device assembly of FIGs. 7A and 7B.
FIGs. 9A and 9B are diagrams illustrating example aspects of an electronic device assembly, such as the electronic device assembly of FIGs. 7A and 7B.
FIG. 10 is a diagram illustrating another example electronic device assembly.
FIGs. 11A to 11D are diagrams illustrating another example electronic device assembly.
FIGs. 12A and 12B are diagrams illustrating example aspects of another electronic device assembly.
FIGs. 13A and 13B are diagrams illustrating example aspects of another electronic device assembly.
FIG. 14 is a diagram illustrating a single body power-tab frame.
FIG. 15 is a flowchart illustrating an example process for producing an electronic device assembly.
FIG. 16 is a flowchart illustrating another example process for producing an electronic device assembly.
FIG. 17 is a flowchart illustrating another example process for producing an electronic device assembly.
FIG. 18 is a flowchart illustrating another example process for producing an electronic device assembly.

Like reference symbols in the various drawings indicate like elements. Reference numbers for some like elements may not be repeated for all such elements. In certain instances, different reference numbers may be used for like, or similar elements. Some reference numbers for certain elements of a given implementation may not be repeated in each drawing corresponding with that implementation. Some reference numbers for certain elements of a given implementation may be repeated in other drawings corresponding with that implementation, but may not be specifically discussed with reference to each corresponding drawing. The drawings are for purposes of illustrating example implementations and may not necessarily be to scale.

### DETAILED DESCRIPTION

This disclosure relates to packaged semiconductor device apparatuses, which can be referred to as modules, assemblies, electronic device assemblies, semiconductor device modules, power semiconductor device modules, etc., as well as associated methods for producing such apparatuses The approaches illustrated and described herein can be used to implement semiconductor device modules (e.g., half-bridge power modules in the example implementations described herein) that can overcome at least some of the drawbacks of prior approaches discussed above. For instance, implementations described herein can facilitate improved molding cavity alignment, reductions in stray inductance, consistent system signal pin arrangements for different modules, reduced signal pin misalignment, and/or reduced delamination of molding compound from an associated thermal dissipation appliance. While the approaches described herein are generally described for half-bridge power modules, in some implementations semiconductor device modules implementing other circuits are possible, such as, for instance, a full-bridge power module, a 3-phase half-bridge module, a multi-phase half-bridge module, etc.

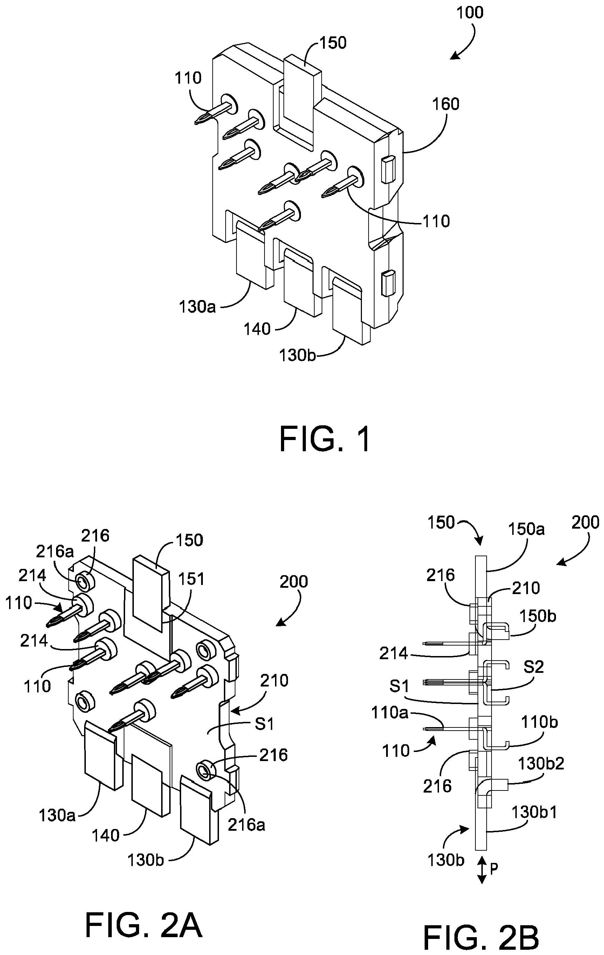

FIG. 1 is a diagram illustrating an example electronic device assembly 100. The electronic device assembly 100 can implement a semiconductor device power module, such as a half-bridge circuit. As shown in FIG. 1, the electronic device assembly 100 includes a plurality of signal pins 110, a positive power tab 130a (positive power supply tab), a positive power tab 130b (positive power supply tab, a negative power tab 140 (negative power supply tab) and an output power tab 150, which, in this example, can be included in a molded body, such as the example molded body illustrated in FIGs. 2A and 2B. The electronic device assembly 100 also includes a molding compound 160, where portions of the plurality of signal pins 110, the positive power tab 130a, the positive power tab 130b, the negative power tab 140 and the output power tab 150 are accessible external to the molding compound 160 (e.g., have portions disposed outside the molding compound 160).

As noted above, the electronic device assembly 100 can include a half-bridge circuit. In some implementations, the half-bridge circuit can be implemented using one or more high-side switches and one or more low-side switches that are included on a substrate and encapsulated in the molding compound 160. For purposes of illustration, in this disclosure, half-bridge circuits including a plurality of high-side switches and a plurality of corresponding low-side switches are described. In some implementations, the high-side switches and the low-side switches can be implemented using power metal-oxide-semiconductor field effect transistors (MOSFETs), such as silicon carbide (SiC) MOSFETs, or can be implemented using insulated-gate bipolar transistors (IGBTs), as some examples.

In such implementations, the positive power tab 130a and the positive power tab 130b can be coupled with the high-side switches (e.g., with drain terminals of MOSFETs or collector terminals of IGBTs). The negative power tab 140 can be coupled with the low-side switches (e.g., with source terminals of MOSFETs or emitter terminals of IGBTs). The output power tab 150 can be coupled with an output node of the half-bridge circuit (e.g., a common node for high side source terminals and low-side drain terminals for MOSFETs, or a common node for high-side emitter terminals and low-side collector terminals for IGBTs). The plurality of signal pins 110 of the electronic device assembly 100 can be used to communicate signals for controlling and/or monitoring operation of the half-bridge circuit, such as gate control signals, voltage sense signals, thermal sensing, etc.

FIGs. 2A and 2B are diagrams illustrating an example molded body 200 that can be included in the electronic device assembly of FIG. 1. Accordingly, the molded body 200 is described with further reference to elements of the electronic device assembly 100 of FIG. 1. FIG. 2A illustrates an isometric view of the molded body 200, and FIG. 2B illustrates a side view of the molded body 200. As shown in FIGs. 2A and 2B, the molded body 200 includes a molded portion 210, which can be formed using, e.g., injection molding. The molded portion 210 includes a surface S1 and a surface S2 that is opposite the planar surface S1.

In this example, the plurality of signal pins 110, the positive power tab 130a, the positive power tab 130b, the negative power tab 140, and the output power tab 150 are integrated in (included in, monolithically incorporated in, etc.) the molded portion 210 of the molded body 200. For instance, in some implementations, the plurality of signal pins and the power tabs can be placed in a molding tool and the molded portion 210 can then be formed, e.g., using injection molding or other molding process, to produce the molded body 200 including the plurality of signal pins and the power tabs.

The molded body 200 shown in FIGs. 2A and 2B includes, on the surface S1, a plurality of protrusions 214 out of which the plurality of signal pins 110 respectively extend. That is, the plurality of protrusions 214 respectively surround portions of the plurality of signal pins 110 proximate the surface S1. The plurality of protrusions 214 can provide mechanical support for the plurality of signal pins 110, e.g., to help prevent misalignment of the signal pins and/or bending of the signal pins.

The molded body 200 also includes, on the surface S1, a plurality of alignment features 216. In this example, the plurality of alignment features 216 are cylindrical protrusions on the surface S1, which define corresponding circular recesses 216a. In some implementations, the circular recesses can be circular through-holes in the molded portion 210. The corresponding circular recesses 216a of the plurality of alignment features 216 can cooperatively interface with pins included in a molding cavity used for forming the molding compound 160 of the electronic device assembly 100. That is, the plurality of alignment features 216 can facilitate alignment of the molded body 200 and an associated substrate as part of a transfer molding process. In some implementations, the protrusions of the plurality of alignment features 216 can be omitted, and the alignment features can be defined as recesses or through-holes in the molded portion 210.

In this example, portions of the power tabs can be disposed in slots defined in the molded portion 210, such as a slot 151 associated with the output power tab 150 indicated in FIG. 2A. These slots can result from the molded portion 210 being formed around the power tabs during, e.g., an injection molding process.

In FIG. 2B, which is a side view of the molded body 200 from a right side of the view shown in FIG. 2A, the molded portion 210 is illustrated as being transparent, such that internal structure of the molded body 200 is visible. As shown in FIG. 2B, each signal pin of the plurality of signal pins 110 includes a portion 110a and a portion 1 10b, where the portion 110a extends out of the surface S1 of the molded portion 210 (e.g., from a respective protrusion of the plurality of protrusions 214), and the portion 110b extends out of the surface S2 of the molded portion 210. The portion 110a and the portion 1 10b, for a given signal pin, are electrically continuous. That is, the portion 110a and the portion 110b can be physically continuous, or can be electrically coupled with each other within the molded portion 210. As shown in FIG. 2B, the portion 110b of each signal pin can include a plurality of bends. These bends can be used to respectively configure the plurality of signal pins 110 to contact a corresponding substrate based on locations of contact pads for the signal pins on the substrate. That is, using an arrangement such as shown in FIG. 2B, a same external signal pin arrangement (portions 110a) can be used for different modules (e.g., different substrate size and layout, different package size, etc.) by appropriately configuring (bending) the internal signal pins portions (portions 110b). This can allow for interchangeability of modules in a given system due to the use of a same external signal pin arrangement for different modules.

FIG. 2B also illustrates the arrangement of the positive power tab 130b and the output power tab 150 in the molded portion 210 of the molded body 200. The other power tabs (the positive power tab 130a and the negative power tab 140) can be similarly arranged, though are not visible in the view of FIG. 2B, as they are disposed behind at least the positive power tab 130b. As shown in FIG. 2B, the positive power tab 130b includes a portion 130b1 and a portion 130b2. Likewise, the output power tab 150 includes a portion 150a and a portion 150b. In this example, the portion 130b1 and the portion 150b are arranged in a plane P and have a surface that is parallel with the surface S1 of the molded portion 210 (on the left side of the view of FIG. 2B and exposed through the molding compound 160. As further shown in FIG. 2B, the portion 130b2 and the portion 150b extend out of the surface S2 of the molded portion and are orthogonal to the plane P. In this example, the positive power tab 130b and the output power tab 150 (as well as the other power tabs) are respective single bodies that are bent to define the portions 130b1 and 130b2 of the positive power tab 130b, and the portions 150a and 150b of the output power tab 150.

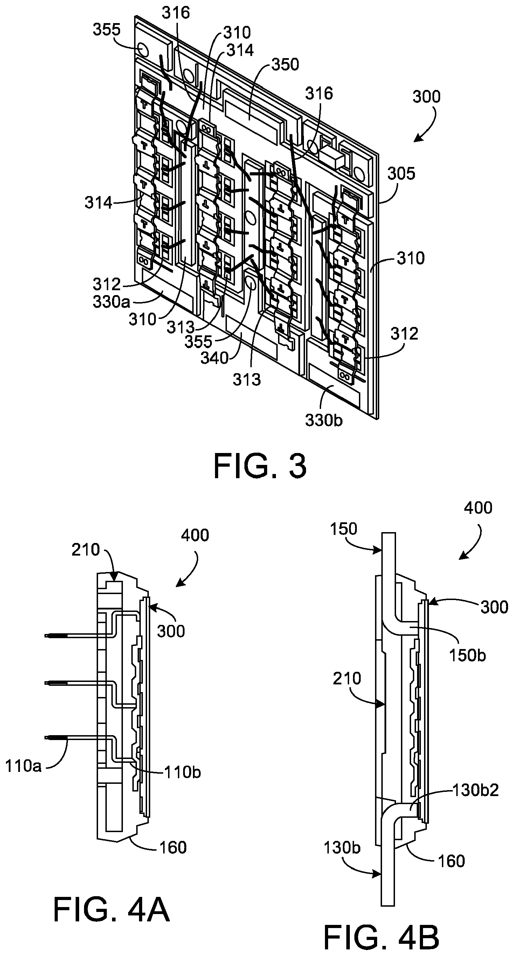

FIG. 3 is a diagram illustrating an example substrate assembly 300. The substrate assembly 300 is given by way of example and for purposes of illustration. The particular arrangement of a substrate assembly will depend on the particular implementation. For instance, a number of transistors can vary, size and location of contact pads can differ, etc. Again, while the substrate assembly 300 is illustrated as implementing a half-bridge circuit, in some implementations, other circuits can be implemented on a substrate assembly that is included in the electronic device assemblies described herein. In this example, the substrate assembly 300 can be included in the electronic device assembly 100 of FIG. 1 and implemented in conjunction with the molded body 200 of FIGs. 2A and 2B. Accordingly, the substrate assembly 300 is described with further reference to elements of the electronic device assembly 100 and the molded body 200.

In the example of FIG. 3, the substrate assembly 300 includes a direct-bonded metal (DBM) substrate, such as a direct-bonded copper (DBC) substrate. The DBM substrate of the substrate assembly 300 includes a ceramic layer 305. A patterned metal layer 310, such as a patterned copper layer, is disposed on (directly bonded to) the ceramic layer 305. The patterned metal layer 310 includes various portions (sections) that are used for implementing the half-bridge circuit of the substrate assembly 300. The substrate assembly 300 further includes a plurality of high-side transistors 312, a plurality of low-side transistors 313, a plurality of conductive clips 314, and a plurality of wire bonds 316. The conductive clips and the wire bonds are used to implement electrical connections to interconnect the plurality of high-side transistors 312, the plurality of low-side transistors 313, and the patterned metal layer 310 to implement the half-bridge circuit.

The substrate assembly 300 also includes a plurality of contact pads defined on the patterned metal layer 310 for coupling signal pins and power tabs with the half-bridge circuit. For instance, the substrate assembly 300 includes a contact pad 330a, a contact pad 330b, a contact pad 340, and a contact pad 350. In the electronic device assembly 100 of FIG. 1, the positive power tab 130a can be coupled with the contact pad 330a, the positive power tab 130b can be coupled with the contact pad 330b, the negative power tab 140 can be coupled with the contact pad 340, and the output power tab 150 can be coupled with the contact pad 350. The substrate assembly 300 also includes a plurality of signal pin contact pads 355 to which the plurality of signal pins 110 (e.g., the portions 110b of the plurality of signal pins 110) can be respectively coupled.

FIGs. 4A and 4B are diagrams illustrating example aspects of an electronic device assembly 400, which can be an implementation of the electronic device assembly 100 of FIG. 1. For instance, the electronic device assembly 400 includes the molded body 200 of FIGs. 2A and 2B, as well as the substrate assembly 300 of FIG. 3. Accordingly, FIGs. 4A and 4B are described with further reference to elements of the electronic device assembly 100, the molded body 200 and the substrate assembly 300. FIGs. 4A and 4B are side views of the electronic device assembly 400, e.g., right side views in arrangement of the electronic device assembly 100 in the view of FIG. 1. In the views of FIGs. 4A and 4B, the molding compound 160 and the molded portion 210 of the molded body 200 are illustrated as being transparent, so as to illustrate internal structure of the electronic device assembly 400. Also, in the views of FIGs. 4A and 4B, one or more elements of the electronic device assembly 400 are not shown for purposes of clarity.

FIG. 4A illustrates connection of the plurality of signal pins 110 with the substrate assembly 300 (e.g., with the plurality of signal pin contact pads 355 of the substrate assembly 300). As shown in FIG. 4A, the molded portion 210 of the molded body 200 is disposed within the molding compound 160, as are the respective portions 110b of the plurality of signal pins 110 extending out of the molded portion 210. As shown in FIG. 4A, the portions 110b of the signal pins 110 are internal to the electronic device assembly 400. That is, the portions 110b are not exposed externally, e.g., are disposed within the molded portion 210 and/or the molding compound 160. Not all signal pins of the electronic device assembly 400 are shown in FIG. 4A, as some of the signal pins are positioned behind, and obscured by the signal pins 110 illustrated in this view. Those obscured signal pins can be similarly coupled with the substrate assembly 300. The plurality of bends in the portions 110b of the plurality of signal pins 110 are configured to align the respective portions 110b with their respective contact pads on the substrate assembly 300. The portions 110b can be coupled with the substrate assembly 300 using solder, sintering, brazing, conductive adhesive, etc.

FIG. 4B illustrates connection of the positive power tab 130b and the output power tab 150 with the substrate assembly 300. The positive power tab 130a and the negative power tab 140 are not shown in FIG. 4B, as they are disposed behind, and obscured by the positive power tab 130b in this view. Those obscured power tabs can be similarly coupled with the substrate assembly 300. As in FIG. 4A, the molded portion 210 of the molded body 200 in FIG. 4B is disposed within the molding compound 160, as are the portion 130b2 of the positive power tab 130b and the portion 150b of the output power tab 150, which extend out of molded portion 210. The portion 130b1 and the portion 150b can be coupled with the substrate assembly 300 using solder, sintering, brazing, conductive adhesive, etc. For instance, the portion 130b1 can be coupled with the contact pad 330b and the portion 150b can be coupled with the contact pad 350.

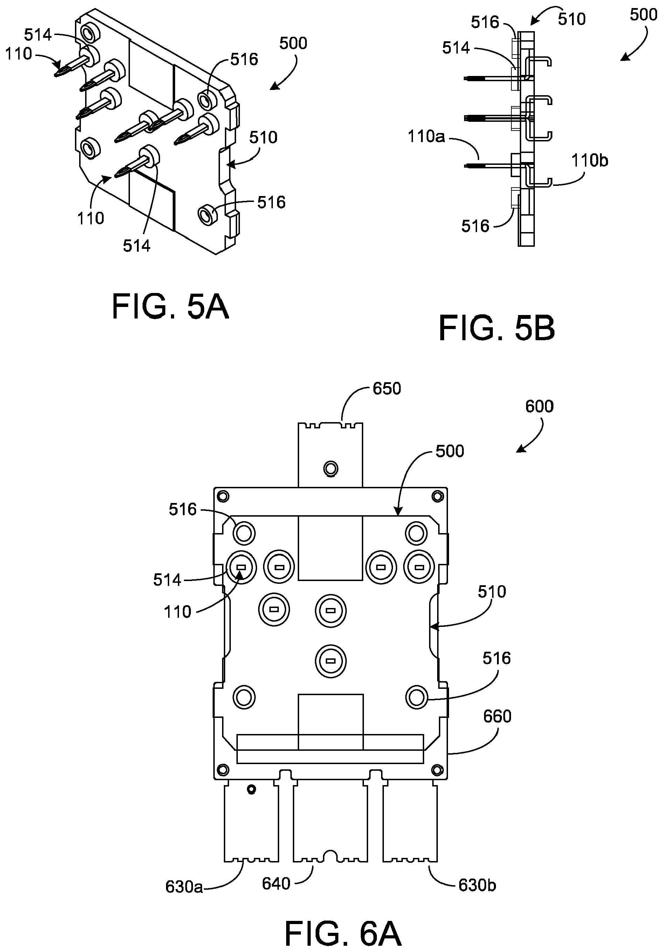

FIGs. 5A and 5B are diagrams illustrating another example molded body 500 that can be included in an electronic device assembly. The molded body 500 includes similar aspects as the molded body 200 of the FIGs. 2A and 2B. For instance, the molded body 500 includes a molded portion 510, a plurality of signal pins 110 (with portions 110a and portions 110b) that are integrated in the molded portion 510, a plurality of protrusions 514 around portions of the signal pins 110, and a plurality of alignment features 516. For purposes of brevity, these features of the molded body 500 are not described again in detail with respect to FIGs. 5A and 5B. As in FIGs. 2A and 2B for the molded body 200, FIG. 5A illustrates an isometric view of the molded body 500, and FIG. 5B illustrates a view of a right side of the molded body 500 as arranged in the view of FIG. 5A. As with FIG. 2B, in the view of FIG. 5B, the molded portion 510 is illustrated as being transparent, such that internal structure of the molded body 500 can be seen.

The molded body 500 differs from the molded body 200 in that the molded body 500 does not include power tabs for an associated electronic device assembly included (integrated, incorporated, etc.) in the molded portion 510. In implementations of electronic device assemblies including the molded body 500, power tabs can be implemented separately from the molded body 500, and coupled with a corresponding substrate assembly, either directly (e.g., using direct-lead attachment), or via respective conductive posts.

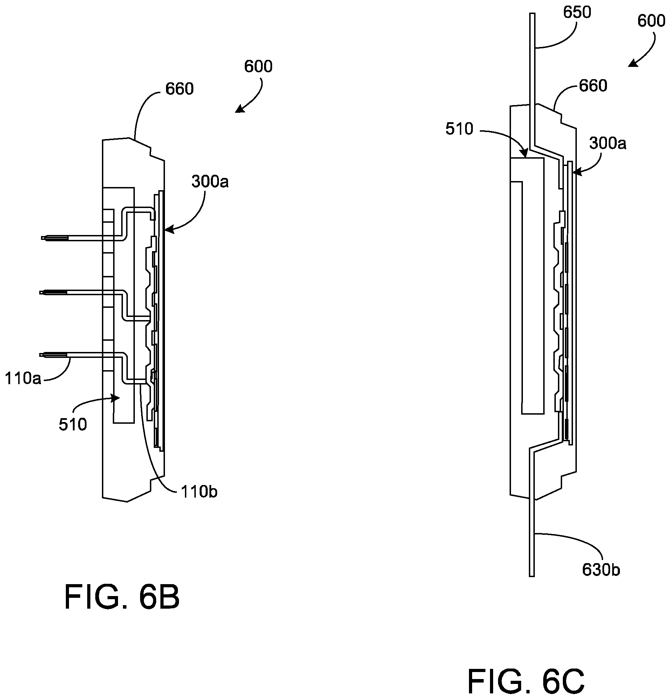

FIGs. 6A to 6C are diagrams illustrating example aspects of an electronic device assembly 600 including the molded body 500 of FIGs. 5A and 5B. Accordingly, elements of the molded body 500 are referenced in views of the electronic device assembly 600 shown in FIGs. 6A to 6C. As with the electronic device assembly 100 and the electronic device assembly 400, the electronic device assembly 600 can implement a half-bridge circuit, though other circuit implementations are possible. FIG. 6A illustrates a front side view of the electronic device assembly 600, while FIGs. 6B and 6C illustrate views from a right side of the electronic device assembly 600 as shown in the view of FIG. 6A. In this example, the molded portion 510 of the molded body 500 can be encapsulated in a molding compound 660. In some implementations, respective upper surfaces of the plurality of protrusions 514 can be exposed through the molding compound 660. For purposes of reference, the molded portion 510 is shown in FIGs. 6A to 6C to illustrate its arrangement in the molding compound 660.

The electronic device assembly 600 includes a positive power tab 630a, a positive power tab 630b, a negative power tab 640, and an output power tab 650. In comparison to the electronic device assembly 100, where surfaces of the power tabs are exposed through the molding compound 160, in the electronic device assembly 600, the power tabs extend from (extend out of) side surfaces, or edges of the molding compound 660. For instance, the positive power tab 630a, the positive power tab 630b, and the negative power tab 640 extend out of a bottom edge of the electronic device assembly 600 in the view of FIG. 6A, while the output power tab 650 extends out of a top edge of the electronic device assembly 600.

In the side views of the electronic device assembly 600 in FIGs. 6B and 6C, as with the side views of the electronic device assembly 400 in FIGs. 4A and 4B, the molding compound 660 and the molded portion 510 of the molded body 500 are illustrated as being transparent, so as to illustrate internal structure of the electronic device assembly 600. Also, in the views of FIGs. 6B and 6C, one or more elements of the electronic device assembly 600 are not shown for purposes of clarity.

FIG. 6B illustrates connection of the plurality of signal pins 110 with a substrate assembly 300a. Depending on the particular implementation, the substrate assembly 300a can be of a same configuration, or of a different configuration than the substrate assembly 300 of FIG. 3. As shown in FIG. 6B, the molded portion 510 of the molded body 500 is disposed within the molding compound 660, as are the respective portions 110b of the plurality of signal pins 110 extending out of the molded portion 510. As shown in FIG. 6A, as with the electronic device assembly 400 as shown in FIG. 4A, the portions 110b of the signal pins 110 are internal to the electronic device assembly 600. That is, the portions 110b are not exposed externally, e.g., are disposed within the molded portion 510 and/or the molding compound 160. Not all signal pins of the electronic device assembly 600 are shown in FIG. 6B, as some of the signal pins are positioned behind, and obscured by the signal pins 110 illustrated in this view. Those obscured signal pins can be similarly coupled with the substrate assembly 300a. The plurality of bends in the portions 110b of the plurality of signal pins 110 are configured to align the respective portions 110b with their respective contact pads on the substrate assembly 300a. In this example, the plurality of signal pins 110 can have a same arrangement and respective functions as the plurality of signal pins 110 of the electronic device assemblies 100 and 400. The portions 110b of the signal pins 110 of the electronic device assembly 600 can be coupled with the substrate assembly 300a using solder, sintering, brazing, conductive adhesive, etc.

FIG. 6C illustrates connection of the positive power tab 630b and the output power tab 650 with the substrate assembly 300a. The positive power tab 630a and the negative power tab 640 are not shown in FIG. 6C, as they are disposed behind, and obscured by the positive power tab 630b in this view. Those obscured power tabs can be similarly coupled with the substrate assembly 300a. As in FIG. 6B, the molded portion 510 of the molded body 500 in FIG. 6C is disposed within the molding compound 660. In this example, respective portions of the positive power tab 630b and the output power tab 650 disposed within the molding compound 660 are bent, and contact surfaces of the bent portions are attached to (coupled to) corresponding contact pads of the substrate assembly 300a. The positive power tab 630b and the output power tab 650 can be coupled with the substrate assembly 300a using solder, sintering, brazing, conductive adhesive, etc.

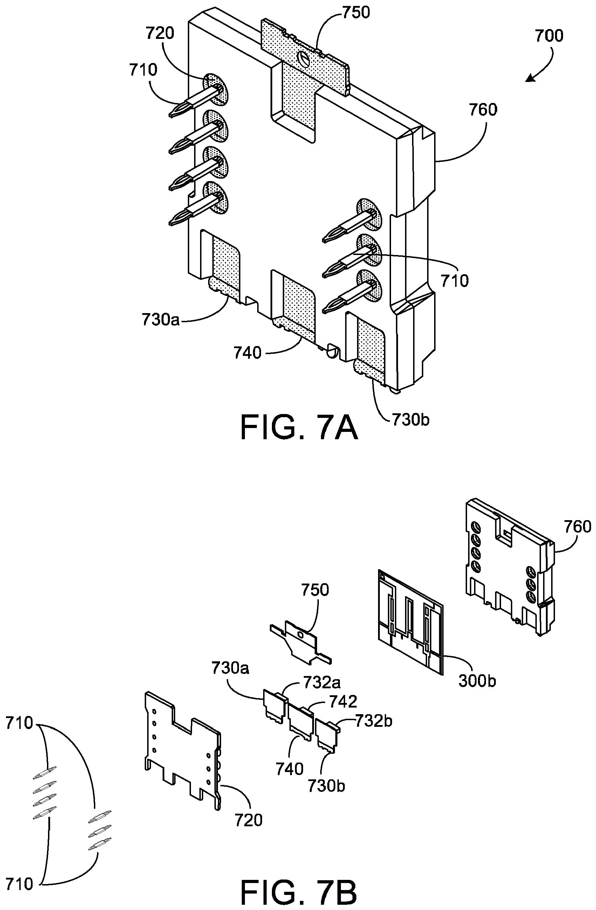

FIGs. 7A and 7B are diagrams illustrating another example electronic device assembly 700. As with the electronic device assembly 100 and the electronic device assembly 400, the electronic device assembly 700 can implement a half-bridge circuit, or other power semiconductor device module. For purposes of illustration, the electronic device assembly 700 is described as implementing a half-bridge circuit. As shown in FIG. 7A, the electronic device assembly 700 includes a plurality of signal pins 710 that are inserted into an interposer 720. The plurality of signal pins 710 can be configured for press-fit insertion in respective signal pin sockets included in the interposer 720. In this example, the plurality of signal pins 710 can also be configured for press-fit insertion in an associated system in which the electronic device assembly 700 is included. In some implementations, the plurality of signal pins 710 can be configured for solder connection in the interposer 720 and/or in an associated system.

The electronic device assembly 700 also includes a positive power tab 730a, a positive power tab 730b, a negative power tab 740, and an output power tab 750. The electronic device assembly 700 also includes a molding compound 760 that encapsulates portions of the electronic device assembly 700. As shown in FIG. 7A, portions of the interposer 720 can be exposed through the molding compound 760, such that the signal pin sockets of the interposer 720 are externally accessible for insertion of the plurality of signal pins 710. As also shown in FIG. 7A, respective surfaces of the power tabs are exposed through the molding compound 760. These surfaces can be used for electrically connecting the power tabs in an associated system.

FIG. 7B is diagram illustrating an exploded view of elements of the electronic device assembly 700 of FIG. 7A. For instance, FIG. 7B illustrates the plurality of signal pins 710, the interposer 720, the positive power tab 730a, the positive power tab 730b, the negative power tab 740, the output power tab 750, and the molding compound 760. In addition, FIG. 7B illustrates a substrate assembly 300b of the electronic device assembly 700. In some implementations, the substrate assembly 300b can be consistent with the substrate assembly 300a of FIG. 3, or can have a different configuration (e.g., size, layout, etc.). FIG. 7B also illustrates a conductive post 732a that is coupled with the positive power tab 730a, a conductive post 732b that is coupled with the positive power tab 730b, and a conductive post 742 that is coupled with the negative power tab 740. While not visible in FIG. 7B, the output power tab 750 can also have one more conductive posts coupled therewith. These conductive posts can facilitate electrically coupling the power tabs with the substrate assembly 300b in the electronic device assembly 700.

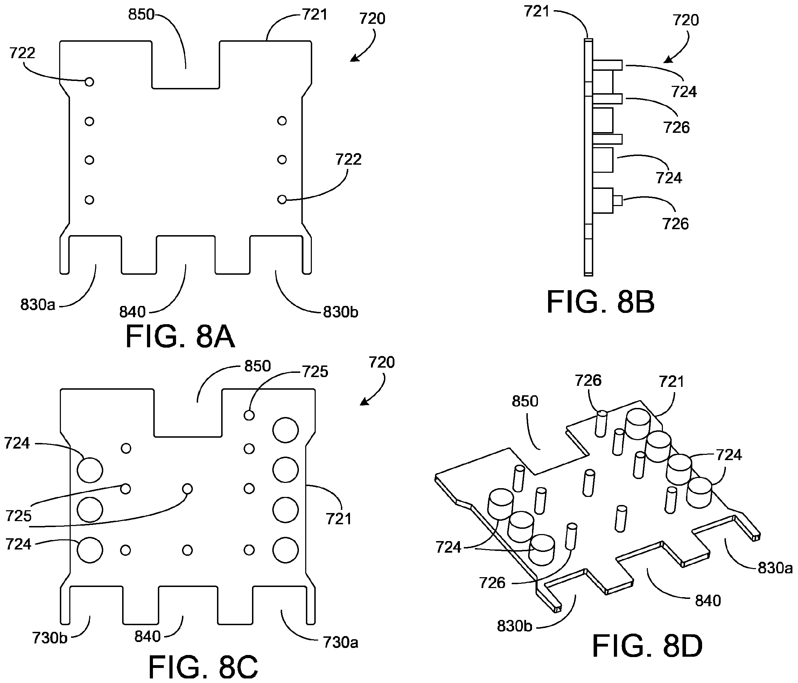

FIGs. 8A to 8D are diagrams illustrating various views of an interposer that can be included in the electronic device assembly 700 of FIGs. 7Aand 7B, e.g., the interposer 720. Accordingly, for purposes of illustration, FIGs. 8A to 8D are described with further reference to the electronic device assembly 700 shown in FIGs. 7A and 7B. FIG. 8A illustrates a front side view of the interposer 720, FIG. 8B illustrates a side view of the interposer 720 from a right side in the view of FIG. 8A. FIG. 8C illustrates a back side view of the interposer 720. FIG. 8D illustrates an isometric view of the back side of the interposer 720 with conductive posts coupled to contact pads of the interposer 720.

As shown in FIG. 8A, the interposer 720 includes a printed circuit board 721. The printed circuit board 721 can include multiple layers and have one or more signal distribution layers (redistribution layers, etc.). The printed circuit board 721 also includes a plurality of signal pin sockets 722, which can be electrically conductive through holes that are electrically coupled, respectively, with printed circuit traces of the one or more redistribution layers. The printed circuit board 721 of the interposer 720 also include a cutout 830a, a cutout 830b, a cutout 840, and a cutout 850. In this example, the power tabs of the electronic device assembly 700 can be respectively disposed in the cutouts of the printed circuit board 721. In some implementations, the power tabs can be monolithically integrated with the interposer 720, such as by being adhesively coupled in the cutouts of the printed circuit board 721.

As shown in the side view of FIG. 8B, the interposer 720 includes a plurality of caps 724 that are disposed on a back side of the printed circuit board 721 of the interposer 720, where the plurality of caps 724 respectively enclose (seal, cover, etc.) the plurality of signal pin sockets 722 on the back side of the interposer 720. In this example, the plurality of caps 724 can prevent molding compound from reaching the plurality of signal pin sockets 722 during molding encapsulation of the electronic device assembly 700, as to prevent the molding compound from interfering with insertion of the plurality of signal pins 710 in the plurality of signal pin sockets 722. The plurality of caps 724 also prevent moisture and/or other contaminants from entering the electronic device assembly 700 through the plurality of signal pin sockets 722. FIG. 8B also illustrates a plurality of conductive posts 726 that are electrically coupled with the printed circuit board 721 of the interposer 720, e.g., with contact pads disposed on the back side of the printed circuit board 721. In this example, the one or more redistribution layers of the printed circuit board 721 can electrically couple the plurality of signal pins 710 respectively with the plurality of conductive posts 726, where the plurality of conductive posts 726 are arranged in correspondence with contact pads on the substrate assembly 300b. As with the molded body 200 and the molded body 500, the redistribution of signals (e.g., from the plurality of signal pins 710 to the plurality of conductive posts 726) can facilitate having a consistent signal pin arrangement for different semiconductor device modules, such as for different package sizes, different contact pad positions on a substrate assembly, etc.

FIG. 8C illustrates a back side of the interposer 720 without the plurality of conductive posts 726. For instance, as shown in FIG. 8C, the printed circuit board 721 includes a plurality of contact pads 725 to which the plurality of conductive posts 726 can be coupled (e.g., via soldering, sintering, brazing, etc.). FIG. 8D illustrates an isometric view of the interposer 720 with the plurality of conductive posts 726 coupled to the plurality of contact pads 725. In some implementations, the plurality of conductive posts 726 can be included with the substrate assembly 300b, rather than the interposer 720. In such implementations, the plurality of conductive posts 726 can then be coupled with the plurality of contact pads 725 during an assembly process for the electronic device assembly 700.

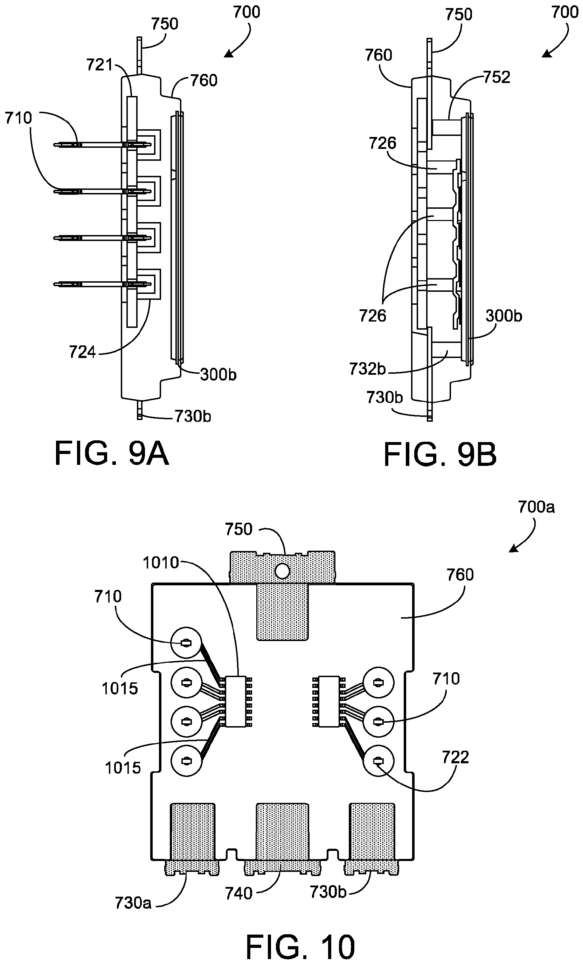

FIGs. 9A and 9B are diagrams illustrating example aspects of an electronic device assembly, such as the electronic device assembly 700 of FIGs. 7A and 7B. Accordingly, FIGs. 9A and 9B are described and illustrated with further reference to elements of the electronic device assembly 700 and the interposer 720. FIGs. 9A and 9B are side views of the electronic device assembly 700, e.g., right side views in arrangement of the electronic device assembly 700 in the view of FIG. 7A. In the views of FIGs. 9A and 9B, the molding compound 760 and/or the plurality of caps 724 are illustrated as being transparent, so as to illustrate internal structure of the electronic device assembly 700. Also, in the views of FIGs. 9A and 9B, one or more elements of the electronic device assembly 700 are not shown for purposes of clarity.

FIG. 9A illustrates the plurality of signal pins 710 after insertion in the plurality of signal pin sockets 722 of the interposer 720. As shown in FIG. 9A, respective portions of the plurality of signal pins 710 are disposed within the plurality of caps 724. The plurality of signal pin sockets 722, the one or redistribution layers of the printed circuit board 721 and the plurality of contact pads 725 can electrically couple the plurality of signal pins 710 with respective conductive posts of the plurality of conductive posts 726. Not all signal pins of the electronic device assembly 700 are shown in FIG. 9A, as some of the signal pins are positioned behind, and obscured by the signal pins 710 illustrated in this view. Those obscured signal pins can be similarly inserted in respective signal pin sockets of the plurality of signal pin sockets 722.

FIG. 9B illustrates electrical connection of the positive power tab 730b and the output power tab 750 with the substrate assembly 300b. The positive power tab 730a and the negative power tab 740 are not shown in FIG. 9B, as they are disposed behind, and obscured by the positive power tab 730b in this view. Those obscured power tabs can be similarly coupled with the substrate assembly 300b. As shown in FIG. 9B, a portion of the positive power tab 730b that is internal to the molding compound 760 is coupled with the substrate assembly 300b via a conductive post 732b, while a portion of the output power tab 750 that is internal to the molding compound 760 is coupled to the substrate assembly 300b via a conductive post 752. The positive power tab 730b and the output power tab 750 can be respectively coupled with the conductive post 732b and the conductive post 752, and the conductive posts 732b and 752 can be coupled with the substrate 300d using solder, sintering, brazing, conductive adhesive, etc.

FIG. 10 is a diagram illustrating another example electronic device assembly 700a. In this example, the electronic device assembly 700a is a variation of the electronic device assembly 700 of FIGs. 7A and 7B. Accordingly, the electronic device assembly 700a is described and illustrated with further reference to the elements of the electronic device assembly 700. As schematically shown in the FIG. 10, at least one electronic component 1010 can be included on the interposer 720 of the electronic device assembly 700a. While visible in FIG. 10, the electronic components 1010, in some implementations, can be disposed within (encapsulated in) the molding compound 760. As also schematically shown in FIG. 10, the electronic components 1010 can be electrically coupled with the plurality of signal pins 710 via a redistribution layer 1015, which can be one of a plurality of redistribution layers of the interposer 720. In some implementations, the electronic components 1010 can include integrated circuits (e.g., gate driver circuits), passive elements (e.g., capacitors, resistors, and/or inductors), etc.

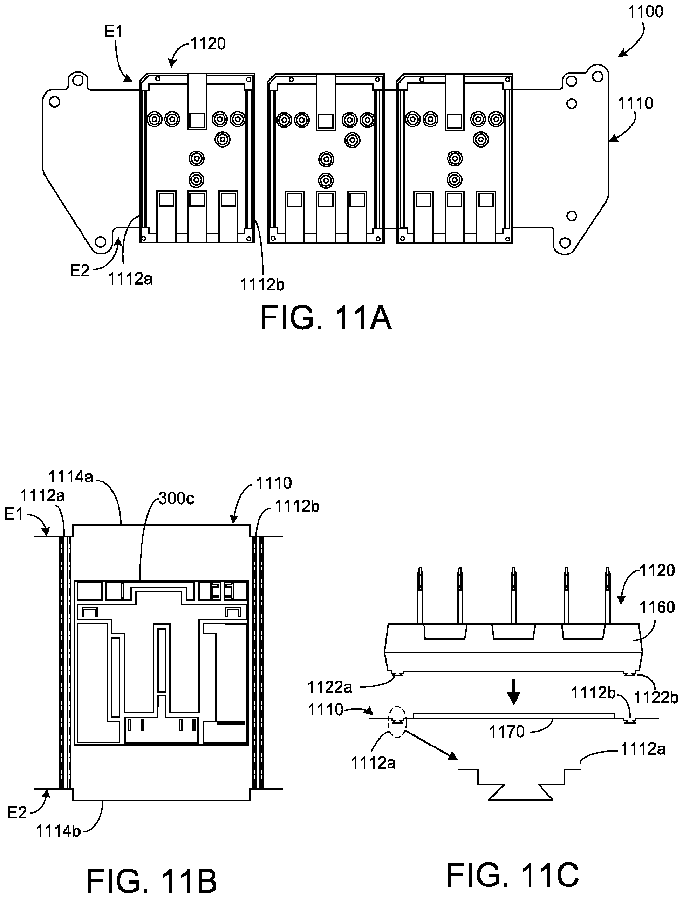

FIGs. 11A to 11D are diagrams illustrating another example electronic device assembly 1100. As shown in FIG. 11A, the electronic device assembly 1100 includes a thermal dissipation appliance 1110, which can be a heat sink or a fluidically-cooled jacket, as two examples. As shown in FIG. 11A, a plurality of semiconductor device modules 1120 can be disposed on the thermal dissipation appliance 1110. In some implementations, the plurality of semiconductor device modules 1120 can be implemented using the approaches described herein. In the electronic device assembly 1100, a surface of the thermal dissipation appliance 1110 can have a plurality of grooves defined therein, where the grooves are configured to anchor molding compound of the plurality of semiconductor device modules 1120 to the surface of the thermal dissipation appliance 1110. For instance, for a given semiconductor device module 1120, a groove 1112a and a groove 1112b can each extend from an edge E1 of the thermal dissipation appliance 1110 to an edge E2 of the thermal dissipation appliance 1110, where the edge E2 is opposite the edge E1. The groove 1112b, in this example, is spaced from and parallel with the groove 1112a.

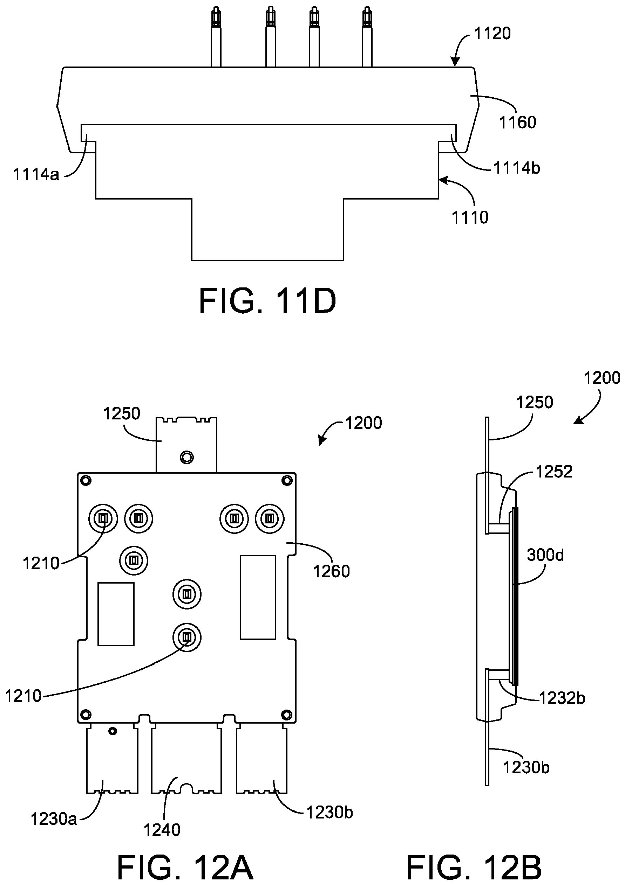

FIG. 11B illustrates a portion of the thermal dissipation appliance 1110 for a given semiconductor device module 1120. As shown in FIG. 11B, a substrate 300c, which can be used to implement a power semiconductor circuit of the given semiconductor device module 1120, can be disposed between the groove 1112a and the groove 1112b. In some implementations, the groove 1112a and the groove 1112b can be formed using machining operations, or during casting of the thermal dissipation appliance 1110. As further shown in FIG. 11B, the thermal dissipation appliance 1110 can include a protrusion 1114a disposed along the edge E1 and a protrusion 1114b disposed along the edge E2. As described further below with respect to FIG. 11D, the protrusion 1114a and the protrusion 1114b can provide for further anchoring of a molding compound of a semiconductor module to the surface of the thermal dissipation appliance 1110.

FIG. 11C illustrates an exploded view of a semiconductor device module 1120 of the electronic device assembly 1100 and a corresponding portion of the surface of the thermal dissipation appliance 1110 on which the semiconductor device module 1120 is disposed in the electronic device assembly 1100. As shown in FIG. 11C, the module 1120 includes a molding compound 1160 encapsulating portions of the module 1120. In this example, the molding compound 1160 includes an anchor portion 1122a corresponding with the groove 1112a, and an anchor portion 1122b corresponding with the groove 1112b. That is, as shown in FIG. 11D, with the substrate 300c of the module 1120 coupled to the thermal dissipation appliance 1110 with sintering material 1170, and after an encapsulation molding operation, the anchor portion 1122a of the molding compound 1160 will be disposed in the groove 1112a, and the anchor portion 1122b of the molding compound 1160 will be disposed in the groove 1112b. FIG. 11C further illustrates a magnified view of the groove 1112a (which can also apply to the groove 1112b), where the groove 1112a (and the groove 1112b) are configured to anchor the molding compound 1160 to the surface of the thermal dissipation appliance 1110 via the anchor portion 1122a and the anchor portion 1122b, respectively.

FIG. 11D illustrates a side view of the module 1120 from a right side of the arrangement shown in FIG. 11A, e.g., with the electronic device assembly 1100 sectioned along the groove 1112b. As shown in FIG. 11D, the molding compound 1160 can extend around and under the protrusion 1114a, and around and under the protrusion 1114b. That is, the molding compound can encapsulate the protrusion 1114a and the protrusion 1114b to provide further anchoring of the molding compound 1160 to the surface of the thermal dissipation appliance 1110. The approach of FIGs. 11 A to 11D can help prevent delamination of the molding compound 1160 from the thermal dissipation appliance 1110 as a result of thermal cycling associated with long term use, and/or during reliability testing.

FIGs. 12A and 12B are diagrams illustrating example aspects of another electronic device assembly 1200. Again, by way of example and for purposes of illustration, the electronic device assembly 1200 is described as implementing a half-bridge circuit. The electronic device assembly 1200 has an external signal pin, e.g., for signal pins 1210, and power tab arrangement that is consistent with the external signal pin and power tab arrangement of the electronic device assembly 600. However, the electronic device assembly 1200, as compared to the electronic device assembly 600 excludes the molded body 500 and differs, at least, in how the power tabs are coupled with a corresponding substrate (a substrate 300d). For instance, the electronic device assembly 1200 includes a positive power tab 1230a, a positive power tab 1230b, a negative power tab 1240, and an output power tab 1250 for the half-bridge circuit. As with the power tabs of the electronic device assembly 600, portions of the power tabs of the electronic device assembly 1200 can extend from (extend out of) edges of a molding compound 1260.

In this example, the power tabs can each include a respective straight body (copper body) that is coupled with a substrate 300c via a respective conductive post. For instance, FIG. 12B illustrates a side view of the electronic device assembly 1200 from a right side of the electronic device assembly 1200 as shown in FIG. 12A. As with the side views of the electronic device assembly 400 (in FIGs.4A and 4B) and the side views of the electronic device assembly 600 (in FIGs. 6B and 6C), the molding compound 1260 is illustrated as being transparent, so as to illustrate internal structure of the electronic device assembly 1200. Also, in the view of FIG. 12B, one or more elements of the electronic device assembly 1200 are not shown for purposes of clarity. FIG. 12B illustrates connection of the positive power tab 1230b and the output power tab 1250 with a substrate 300d. The positive power tab 1230b and the negative power tab 1240 are not shown in FIG. 12B, as they are disposed behind, and obscured by the positive power tab 1230b in this view. Those obscured power tabs can be similarly coupled with the substrate 300d.

As shown in FIG. 12B, a portion of the positive power tab 1230b that is internal to the molding compound 1260 is coupled with the substrate 300d via a conductive post 1232b, while a portion of the output power tab 1250 that is internal to the molding compound 1260 is coupled to the substrate 300d via a conductive post 1252. The positive power tab 1230b and the output power tab 1250 can be respectively coupled with the conductive post 1232b and the conductive post 1252, and the conductive posts 1232b and 1252 can be coupled with the substrate 300d using solder, sintering, brazing, conductive adhesive, etc.

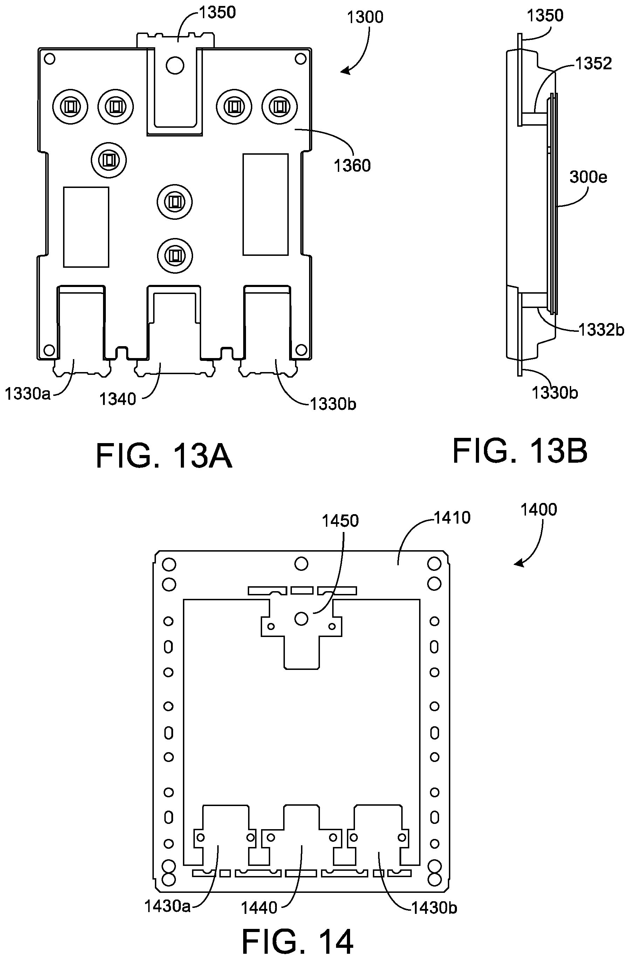

FIGs. 13A and 13B are diagrams illustrating example aspects of another electronic device assembly 1300. Again, by way of example and for purposes of illustration, the electronic device assembly 1300 is described as implementing a half-bridge circuit. As compared with the electronic device assembly 1200, the electronic device assembly 1300 has an external power tab arrangement where respective surfaces of the power tabs are exposed through a molding compound 1360. For instance, the electronic device assembly 1300 includes a positive power tab 1330a, a positive power tab 1330b, a negative power tab 1340, and an output power tab 1350 for the half-bridge circuit, each having a surface exposed through the molding compound 1360. As with the power tabs of the electronic device assembly 1200, the power tabs of the electronic device assembly 1300 can each include a respective straight body (copper body) that is coupled with a substrate 300c via a respective conductive post.

For instance, FIG. 13B illustrates a side view of the electronic device assembly 1300 from a right side of the electronic device assembly 1300 as shown in FIG. 13A. As with the side view of the electronic device assembly 1200 in FIG. 12A, the molding compound 1360 is illustrated as being transparent, so as to illustrate internal structure of the electronic device assembly 1300. Also, in the view of FIG. 13B, one or more elements of the electronic device assembly 1300 are not shown for purposes of clarity. FIG. 13B illustrates connection of the positive power tab 1330b and the output power tab 1350 with a substrate 300e. The positive power tab 1330b and the negative power tab 1340 are not shown in FIG. 13B, as they are disposed behind, and obscured by the positive power tab 1330b in this view. Those obscured power tabs can be similarly coupled with the substrate 300e.

As shown in FIG. 13B, a portion of the positive power tab 1330b that is internal to the molding compound 1360 is coupled with the substrate 300e via a conductive post 1332b, while a portion of the output power tab 1350 that is internal to the molding compound 1360 is coupled to the substrate 300e via a conductive post 1352. The positive power tab 1330b and the output power tab 1350 can be respectively coupled with the conductive post 1332b and the conductive post 1352, and the conductive posts 1332b and 1352 can be coupled with the substrate 300d using solder, sintering, brazing, conductive adhesive, etc.

The power tabs arrangements of the electronic device assembly 1200 and electronic device assembly 1300, due to the use of straight body power tabs and conductive posts can reduce stray inductance as compared to previous implementations. For instance, such implementations can reduce stray inductance as a result of reducing overall conduction lengths associated with power tabs and/or reducing variation in current path direction in the power tab current paths. In the examples described herein, conductive posts can be, e.g., copper posts.

FIG. 14 is a diagram illustrating a single body power-tab frame 1400. In some implementations, the single body power-tab frame 1400 can be used to produce the electronic device assembly 1300 of FIGs. 13A and 13B. A similar single body power-tab frame can be used to produce the electronic device assembly 1200 of FIGs. 12A and 12B. As shown in FIG. 14, the single body power-tab frame 1400 includes a frame portion 1410, a power tab 1430a (e.g., positive power tab), a power tab 1430b (e.g., positive power tab), a power tab 1440 (e.g., a negative power tab), and a power tab 1450 (e.g., an output power tab). The power tabs and the frame portion 1410 of the single body power-tab frame 1400 are formed as single body, e.g., using a stamping process. The power tabs of the single body power-tab frame 1400 can, during a module assembly process, be coupled with a substrate of an electronic device assembly using, e.g., respective conductive posts, such as in the approached described herein. The frame portion 1410 can then be used as an alignment mechanism for positioning the substrate in a molding cavity for encapsulation molding (e.g., transfer molding). This can help prevent misalignment of the substrate in the molding cavity. After completing the molding process, the power tabs can be separated from the frame portion 1410 using a trimming process.

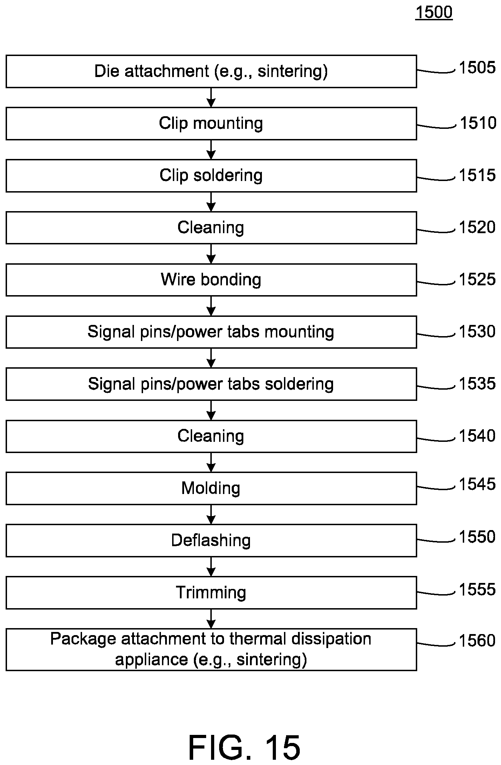

FIG. 15 is a flowchart illustrating an example process 1500 for producing an electronic device assembly. In some implementations, the process 1500 can be used to produce the electronic device assembly 100 of FIG. 1, which can implement a semiconductor device power module, such as half-bridge circuit, as one example. As shown in FIG. 15, the process 1500 includes, at block 1505, sintering one or more semiconductor die to a substrate, such as to a patterned metal layer of a DBM substrate. In some implementations, other approaches can be used for coupling semiconductor die to a substrate, such soldering, brazing, conductive adhesive, etc. At block 1510, the process 1500 includes placing (arranging, mounting, etc.) one or more conductive clips on the semiconductor die and/or a patterned metal layer on the substrate. The operation at block 1510 can include performing a solder print operation to apply electrical solder on surfaces of the semiconductor die and/or patterned metal layer to which respective surfaces of the conductive clips will be attached. At block 1515, the process 1500 includes performing a soldering operation to electrically and physically couple the conductive clips of block 1510 with the semiconductor die and/or the patterned metal layer. At block 1520, the process 1500 includes a cleaning operation (e.g., a solder flux cleaning operation) to remove flux from the soldering operation at block 1515. At block 1525, the process 1500 includes forming wire bonds between the semiconductor die and the patterned metal layer.

The process 1500 further includes, at block 1530, placing (arranging, mounting, etc.) one more signal pins and one or more power tabs on the patterned metal layer of the substrate. The signal pins and/or the power tabs can be included in a molded body, such as the molded body of FIGs. 2A and 2B (including both signal pins and power tabs), or the molded body of FIGs. 5Aand 5B (including signal pins). The operation at block 1530 can include performing a solder print operation to apply electrical solder on surfaces of the patterned metal layer to which respective surfaces of the signal pins and the power tabs will be attached. At block 1535, the process 1500 includes performing a soldering operation to electrically and physically couple the signal pins and power tabs of block 1530 with the patterned metal layer. At block 1540, the process 1500 includes a cleaning operation (e.g., a solder flux cleaning operation) to remove flux from the soldering operation at block 1535.

At block 1545, the process 1500 includes a molding operation (e.g., a transfer molding operation), which can be performed to encapsulate portions of the electronic device assembly being produced. At block 1550, the process 1500 includes a deflashing operation to remove excess molding compound from the molding operation of block 1545. At block 1555, the process 1500 includes a trimming operation to separate the power tabs from an associated frame. In some implementations, e.g., where the power tabs are included in a molded body, such as the molded body 200 of FIGs. 2A and 2B, the trimming operation at block 1555 can be omitted. At block 1560, the packaged semiconductor device assembly produced at blocks 1505 to 1555 can be attached, by sintering, to a thermal dissipation appliance (device, mechanism, etc.), such as a heat sink, or a fluidically-cooled jacket. Other attachment approaches can be used at block 1560, such as soldering, brazing, thermally conductive adhesive, etc.

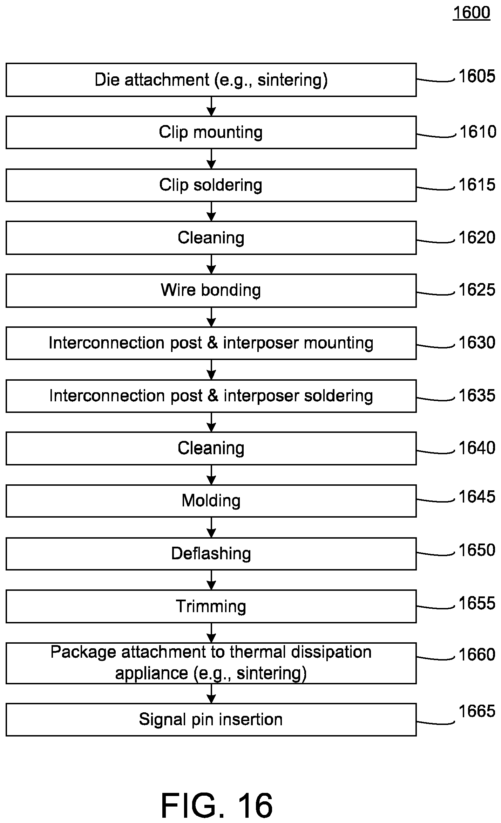

FIG. 16 is a flowchart illustrating another example process 1600 for producing an electronic device assembly. In some implementations, the process 1600 can be used to produce the electronic device assembly 700 of FIG. 7A, which can implement a semiconductor device power module, such as half-bridge circuit, as one example. As shown in FIG. 16, the process 1600 includes, at block 1605, sintering one or more semiconductor die to a substrate, such as to a patterned metal layer of a DBM substrate. In some implementations, other approaches can be used for coupling semiconductor die to a substrate, such as soldering, brazing, conductive adhesive, etc. At block 1610, the process 1600 includes placing (arranging, mounting, etc.) one or more conductive clips on the semiconductor die and/or a patterned metal layer on the substrate. The operation at block 1610 can include performing a solder print operation to apply electrical solder on surfaces of the semiconductor die and/or patterned metal layer to which respective surfaces of the conductive clips will be attached. At block 1615, the process 1600 includes performing a soldering operation to electrically and physically couple the conductive clips of block 1610 with the semiconductor die and/or the patterned metal layer. At block 1620, the process 1600 includes a cleaning operation (e.g., a solder flux cleaning operation) to remove flux from the soldering operation at block 1615. At block 1625, the process 1600 includes forming wire bonds between the semiconductor die and the patterned metal layer.

The process 1600 further includes, at block 1630, placing (arranging, mounting, etc.) a plurality of conductive posts on the patterned metal layer of the substrate. The operation at block 1630 can also include respectively placing (arranging, mounting, etc.) an interposer (e.g., the interposer 720) and one or more power tabs on the conductive posts. In some implementations, the conductive posts can be included with the interposer, with the substrate, and/or with the power tabs. The operation at block 1630 can include performing a solder print operation to apply electrical solder on surfaces of the patterned metal layer and/or contact pads of the interposer to which respective surfaces of the signal pins, conductive posts, and/or the power tabs will be attached. At block 1635, the process 1600 includes performing a soldering operation to electrically and physically couple the conductive posts with the patterned metal layer, the contact pads of the interposer, and/or the one or more power tabs. At block 1640, the process 1600 includes a cleaning operation (e.g., a solder flux cleaning operation) to remove flux from the soldering operation at block 1635.

At block 1645, the process 1600 includes a molding operation (e.g., a transfer molding operation), which can be performed to encapsulate portions of the electronic device assembly being produced. At block 1650, the process 1600 includes a deflashing operation to remove excess molding compound from the molding operation of block 1645. At block 1655, the process 1600 includes a trimming operation to separate the power tabs from an associated frame. In some implementations, e.g., where the power tabs are monolithically included in the interposer, the trimming operation at block 1655 can be omitted. At block 1660, the packaged semiconductor device assembly produced at blocks 1605 to 1655 can be attached, using sintering, to a thermal dissipation appliance (device, mechanism, etc.), such as a heat sink, or a fluidically-cooled jacket. Other attachment approaches can be used at block 1660, such as soldering, brazing, thermally conductive adhesive, etc. At block 1665, signal pins can be inserted (e.g., press-fit) into signal pin sockets of the interposer.

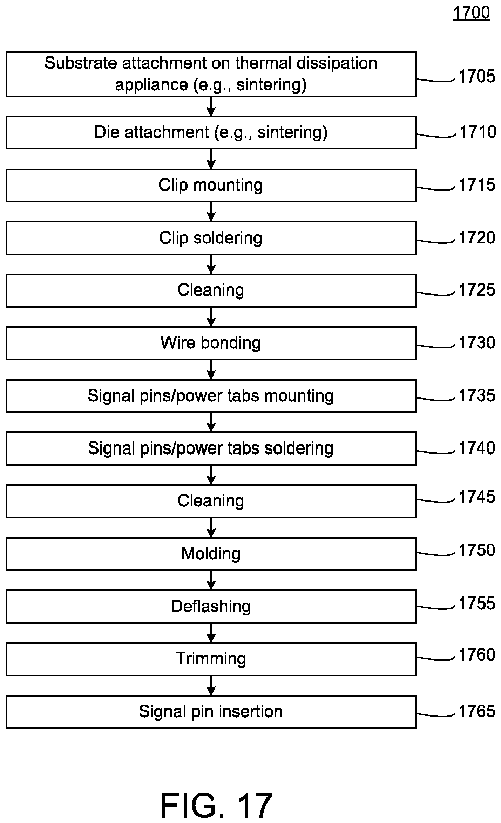

FIG. 17 is a flowchart illustrating another example process 1700 for producing an electronic device assembly. In some implementations, the process 1700 can be used to produce the electronic device assembly 1100 of FIG. 11A, which can include a plurality of semiconductor device power modules, such as half-bridge circuits, disposed on a heat sink or fluidically-cooled jacket. As shown in FIG. 17, the process 1700, at block 1705, includes sintering one or more substrates (e.g., DBM substrates) to the thermal dissipation appliance. In some implementations, other processes can be used to couple the one or more substrates with the thermal dissipation appliance, such as soldering, brazing, conductive adhesive, etc. At block 1710, the process 1700 includes sintering one or more semiconductor die to each of the one or more substrates, such as to patterned metal layers of DBM substrates. In some implementations, other approaches can be used for coupling semiconductor die to the substrates, such as soldering, brazing, conductive adhesive, etc.

At block 1715, the process 1700 includes placing (arranging, mounting, etc.) one or more conductive clips on the semiconductor die and/or patterned metal layers on the substrates. The operation at block 1715 can include performing a solder print operation to apply electrical solder on surfaces of the semiconductor die and/or patterned metal layers to which respective surfaces of the conductive clips will be attached. At block 1720, the process 1700 includes performing a soldering operation to electrically and physically couple the conductive clips of block 1715 with the semiconductor die and/or the patterned metal layers. At block 1725, the process 1700 includes a cleaning operation (e.g., a solder flux cleaning operation) to remove flux from the soldering operation at block 1720. At block 1730, the process 1700 includes forming wire bonds between the semiconductor die and the patterned metal layers.

The process 1700 further includes, at block 1735, placing (arranging, mounting, etc.) signal pins (or conductive posts of an interposer assembly) and power tabs on the patterned metal layers of the substrates. In some implementations, the signal pins, conductive posts and/or the power tabs can be included in a molded body or interposer assembly, such as those described herein. In some implementations, such as implementations using press-fit signal pins, applying signal pins can be omitted at block 1735. The operation at block 1735 can include performing a solder print operation to apply electrical solder on surfaces of the patterned metal layer to which respective surfaces of the signal pins, conductive posts, and/or the power tabs will be attached. At block 1740, the process 1700 includes performing a soldering operation to electrically and physically couple the signal pins, conductive posts, and/or the power tabs of block 1735 with the patterned metal layers. At block 1745, the process 1700 includes a cleaning operation (e.g., a solder flux cleaning operation) to remove flux from the soldering operation at block 1740.

At block 1750, a molding operation (e.g., a transfer molding operation) can be performed to encapsulate portions of the electronic device assemblies being produced on the thermal dissipation appliance, such as the molding compound 1160 illustrated in FIGs. 11C and 11D. At block 1755, the process 1700 includes a deflashing operation to remove excess molding compound from the molding operation of block 1750. At block 1760, the process 1700 includes a trimming operation to separate the power tabs from an associated frame. In some implementations, e.g., where the power tabs are monolithically included in a molded body or interposer, the trimming operation at block 1760 can be omitted. At block 1765, signal pins, e.g., press-fit signal pins, are inserted. In implementations where signal pins are applied at block 1735, and soldered at block 1740, the signal pin insertion operation of block 1765 can be omitted.

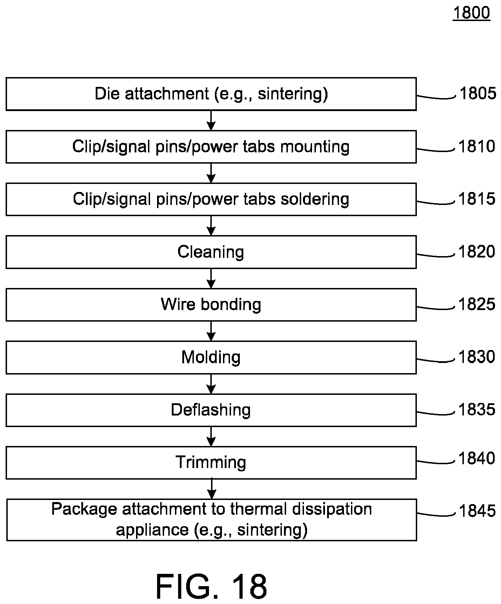

FIG. 18 is a flowchart illustrating another example process 1800 for producing an electronic device assembly. In some implementations, the process 1800 can be used to produce the electronic device assembly 1200 of FIG. 12A or the electronic device assembly 1300 of FIG. 13A, which can implement a semiconductor device power module, such as a half-bridge circuit. As shown in FIG. 18, the process 1800 includes, at block 1805, sintering one or more semiconductor die to a substrate, such as to a patterned metal layer of a DBM substrate. In some implementations, other approaches can be used for coupling semiconductor die to a substrate, such soldering, brazing, conductive adhesive, etc. At block 1810, the process 1800 includes placing (arranging, mounting, etc.) one or more conductive clips, one or more signal pins, one or more conductive posts, and/or one or more conductive tabs of the electronic device assembly. The operation at block 1810 can include performing a solder print operation to apply electrical solder for coupling corresponding surfaces with one another. At block 1815, the process 1800 includes performing a soldering operation to electrically and physically couple surfaces the conductive clips, the signal pins, the conductive posts, and/or the power tabs of block 1810 with corresponding surfaces of the semiconductor die and/or the patterned metal layer. At block 1820, the process 1800 includes a cleaning operation (e.g., a solder flux cleaning operation) to remove flux from the soldering operation at block 1815. At block 1825, the process 1800 includes forming wire bonds between the semiconductor die and the patterned metal layer.

At block 1830, the process 1800 includes a molding operation (e.g., a transfer molding operation), which can be performed to encapsulate portions of the electronic device assembly being produced. At block 1835, the process 1800 includes a deflashing operation to remove excess molding compound from the molding operation of block 1830. At block 1840, the process 1800 includes a trimming operation to separate the power tabs from an associated frame. At block 1845, the packaged semiconductor device assembly produced at blocks 1805 to 1840 can be attached to (coupled with, etc.) a thermal dissipation appliance (device, mechanism, etc.), such as a heat sink, or a fluidically-cooled jacket. Other attachment approaches can be used at block 1845, such as soldering, brazing, thermally conductive adhesive, etc.

It will be understood that, in the foregoing description, when an element, such as a layer, a region, or a substrate, is referred to as being on, connected to, electrically connected to, coupled to, or electrically coupled to another element, it may be directly on, connected or coupled to the other element, or one or more intervening elements may be present. In contrast, when an element is referred to as being directly on, directly connected to or directly coupled to another element or layer, there are no intervening elements or layers present. Although the terms directly on, directly connected to, or directly coupled to may not be used throughout the detailed description, elements that are shown as being directly on, directly connected or directly coupled can be referred to as such. The claims of the application may be amended to recite exemplary relationships described in the specification or shown in the figures.

As used in this specification, a singular form may, unless definitely indicating a particular case in terms of the context, include a plural form. Spatially relative terms (e.g., over, above, upper, under, beneath, below, lower, top, bottom, and so forth) are intended to encompass different orientations of the device in use or operation in addition to the orientation depicted in the figures. In some implementations, the relative terms above and below can, respectively, include vertically above and vertically below In some implementations, the term adjacent can include laterally adjacent to or horizontally adjacent to.

Some implementations may be implemented using various semiconductor processing and/or packaging techniques. Some implementations may be implemented using various types of semiconductor device processing techniques associated with semiconductor substrates including, but not limited to, for example, silicon (Si), silicon carbide (SiC), gallium arsenide (GaAs), gallium nitride (GaN), and/or so forth.

While certain features of the described implementations have been illustrated as described herein, many modifications, substitutions, changes and equivalents will now occur to those skilled in the art. It is, therefore, to be understood that the appended claims are intended to cover all such modifications and changes as fall within the scope of the implementations. It should be understood that they have been presented by way of example only, not limitation, and various changes in form and details may be made. Any portion of the apparatus and/or methods described herein may be combined in any combination, except mutually exclusive combinations. The implementations described herein can include various combinations and/or subcombinations of the functions, components and/or features of the different implementations described.

## Claims

1. An electronic device assembly comprising:
a substrate having a surface;
a patterned metal layer disposed on the surface of the substrate;
a semiconductor device circuit implemented on the patterned metal layer; and
a molded body including a plurality of signal pins, a signal pin of the plurality of signal pins including:
a first portion extending out of a first surface of the molded body, the first portion being externally accessible; and
a second portion extending out of a second surface of the molded body opposite the first surface, the second portion:
being internal in the electronic device assembly;
electrically coupled with the patterned metal layer; and
electrically continuous with the first portion.

2. The electronic device assembly of claim 1, wherein the second portion of the signal pin includes a plurality of bends.

3. The electronic device assembly of claim 1, wherein the molded body includes a plurality of alignment features configured to position the electronic device assembly in an encapsulation molding tool, the plurality of alignment features including at least one of:
a plurality of recesses in the first surface of the molded body; or
a plurality of through-holes in the molded body.

4. The electronic device assembly of claim 1, wherein the molded body further includes a plurality of power tabs, a power tab of the plurality of power tabs including:
a first portion arranged in a plane parallel to the first surface of the molded body; and
a second portion orthogonal to the first portion, the second portion of the power tab:
extending from the second surface of the molded body;
being electrically continuous with the first portion of the power tab; and
being electrically coupled with the patterned metal layer.

5. The electronic device assembly of claim 4, wherein:
the first portion of the power tab is disposed in a slot defined in the molded body; and
the power tab is a single body that is bent to define the first portion of the power tab and the second portion of the power tab.

6. The electronic device assembly of claim 4, wherein the second portion of the power tab is a conductive post that electrically couples the first portion of the power tab with the patterned metal layer.

7. An electronic device assembly comprising:
a substrate having a surface;
a patterned metal layer disposed on the surface of the substrate;
a semiconductor device circuit implemented on the patterned metal layer;
an interposer having a first side and a second side opposite the first side, the interposer including:
a plurality of signal pin sockets accessible from the first side of the interposer;
a plurality of caps respectively enclosing the plurality of signal pin sockets on the second side of the interposer; and
at least one signal redistribution layer respectively electrically coupling the plurality of signal pin sockets to a plurality of contact pads on the second side of the interposer; and
a plurality of electrically conductive posts respectively electrically coupling the plurality of contact pads with the patterned metal layer.

8. The electronic device assembly of claim 7, further comprising at least one electrical component disposed on the first side of the interposer, the at least one electrical component being electrically coupled with at least one signal pin socket of the plurality of signal pin sockets via the at least one signal redistribution layer.

9. The electronic device assembly of claim 7, wherein the interposer includes a printed circuit board.

10. The electronic device assembly of claim 7, wherein the interposer further includes a plurality of cutouts, the electronic device assembly further comprising:
a plurality of power tabs respectively disposed in the plurality of cutouts; and
a plurality of conductive posts respectively electrically coupling the plurality of power tabs with the patterned metal layer.

11. The electronic device assembly of claim 7, further comprising:
a molding compound, the plurality of signal pin sockets being exposed through the molding compound; and
a plurality of signal pins respectively inserted in the plurality of signal pin sockets.

12. An electronic device assembly comprising:
a thermal dissipation appliance having a surface, the thermal dissipation appliance including:
a first groove defined in the surface; and
a second groove defined in the surface, the second groove being spaced from and parallel to the first groove;
a substrate coupled with a surface of the thermal dissipation appliance, the substrate being disposed between the first groove and the second groove;
a semiconductor device circuit implemented on the substrate; and
a molding compound, a first portion of the molding compound encapsulating the substrate and the semiconductor device circuit, a second portion of the molding compound being disposed in the first groove, and a third portion of the molding compound being disposed in the second groove.

13. The electronic device assembly of claim 12, wherein:
the first groove extends from a first edge of the thermal dissipation appliance to a second edge of the thermal dissipation appliance, the second edge being opposite the first edge; and
the second groove extends from the first edge of the thermal dissipation appliance to the second edge of the thermal dissipation appliance,
the thermal dissipation appliance further including:
a first protrusion disposed along the first edge of the thermal dissipation appliance between the first groove and the second groove, a fourth portion of the molding compound encapsulating the first protrusion; and
a second protrusion disposed along the second edge of the thermal dissipation appliance between the first groove and the second groove, a fifth portion of the molding compound encapsulating the second protrusion.

14. The electronic device assembly of claim 12, wherein the thermal dissipation appliance is one of:
a heat sink; or
a fluidically-cooled jacket.

15. The electronic device assembly of claim 12, further comprising:
a plurality of externally accessible signal pins; and
a plurality of externally accessible power tabs.
